# EUROPEAN PATENT APPLICATION

(11) **EP 2 134 146 A1**
(43) Date of publication of application: **16.12.2009**
(21) Application number: 08010446.6
(22) Date of filing: 09.06.2008
(51) Int. Cl.: H05K 3/34

(54) **Printed circuit board assembly and a method of assembling thereof**

(71) Applicant: Volohovs, Dmitrijs, Riga LV 1082 (LV); Mironovs, Sergejs, Riga LV 1082 (LV)
(72) Inventor: Volohovs, Dmitrijs, Riga LV 1082 (LV); Mironovs, Sergejs, Riga LV 1082 (LV)
(74) Representative: Anohins, Vladimirs

(57) **Abstract**

The invention provides a printed circuit board assembly (10) comprising a printed circuit board (12), having a first major surface (14), a second major surface (16), and an edge surface (18); a first electronic component (22) mounted on the first major surface (14), a second electronic component (24) mounted on the second major surface (16), and a third electronic component (32) disposed atop the edge surface (18), wherein a first contact terminal (34) of the third electronic component (32) is surface mounted to a contact terminal (26) of the first electronic component (22), and a second contact terminal (34) of the third electronic component (32) is surface mounted to a contact terminal (26) of the second electronic component (24). In other words, a contact terminals (26) of the first and second electronic components (22, 24) mounted on the opposite sides (16, 18) of the printed circuit boards (12) serve as mounting pads for the third electronic component (32) which is mounted atop or across the edge surface (18) of the PCB (12) by the way of surface mount technology. The invention also provides a method for assembling a printed circuit board assembly having SMT type electronic components mounted over the PCB edge using surface mount technology.

## Description

### FIELD OF THE INVENTION

The present invention is generally directed to a printed circuit board assembly. More particularly, the invention relates to a printed circuit board assembly having electronic components mounted over the printed circuit board edge and a method of assembling thereof.

### BACKGROUND OF THE INVENTION

A printed circuit board, or PCB, is used to mechanically support and electrically connect electronic components using conductive pathways, or traces, etched from copper sheets laminated onto a non-conductive substrate. Alternative names are printed wiring board (PWB). A PCB populated with electronic components is a printed circuit assembly, also known as a printed circuit board assembly (PCBA)

Surface mount technology (SMT) is a method for constructing electronic circuits in which the electronic components are mounted directly onto the surface of printed circuit boards (PCBs). In the industry it has largely replace the through-hole technology construction method of fitting components with wire leads into holes in the circuit board.

Commonly, the electronic components are mounted on one or both major surfaces of a PCB. However, it sometimes is advantageous to mount an electronic component atop or over the PCB edge.

An example of a PCB comprising numerous electronic components mounted over the edge of the PCB may be found in US 2007/0030679 A1 to Lee. It describes a light emitting diode display device comprising a plurality of pieces of long printed circuit boards (PCBs), each comprising numerous light emitting diode (LED) lamps which straddle over the edges of the PCBs, the pins of LED lamps being soldered to the copper foil-layer on the PCB surface.

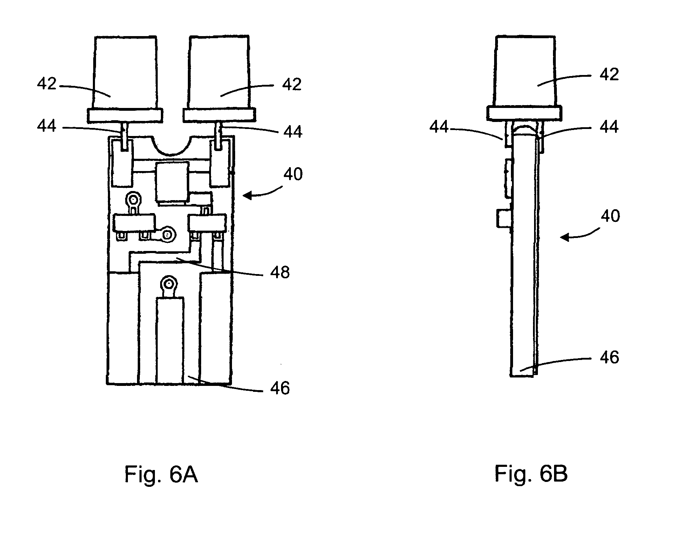

Another example may be found in EP 1 383 363 A2 to Gamesman Limited entitled "Circuit board with directly mounted lamps". As shown on FIG. 6A and 6B, this application describes a lamp assembly 40, which has one or more LED lamps 42 with terminals 44 attached to a circuit board 46 so as to be supported by the board 46. The lamp terminals 44 are attached to positions on the pathways 48 on opposite sides of the board 46 so that the lamp 42 straddles the board 46, preferably symmetrically.

A problem with these prior art examples is that the mounting of an electronic component over the PCB edge is incompatible with convenient SMT process and require use of components with wire leads that are hand soldered to the PCB, thereby leading to high production cost.

### SUMMARY OF THE INVENTION

Accordingly, an object of the present invention is to provide a printed circuit board assembly having SMT type electronic components mounted over the PCB edge capable of being assembled by the use of surface mount technology.

It is another object to provide such an assembly which is relatively compact and inexpensive to manufacture, and to provide a relatively fast and inexpensive method of manufacturing such an assembly.

These objects are achieved in that the printed circuit board assembly comprises a printed circuit board, having a first major surface, a second major surface, and an edge surface; a first electronic component mounted on the first major surface, a second electronic component mounted on the second major surface, and a third electronic component disposed atop the edge surface, wherein a first contact terminal of the third electronic component is surface mounted to a contact terminal of the first electronic component, and a second contact terminal of the third electronic component is surface mounted to a contact terminal of the second electronic component. In other words, a contact terminals of the first and second electronic components mounted on the opposite sides of the printed circuit boards serve as a mounting pads for the third electronic component which is mounted atop or across the edge surface of the PCB by the way of surface mount technology. Thus, the third component is an edge component.

The invention also relates to a method of assembling a printed circuit board assembly comprising steps of: a) providing a PCB having a first surface a second surface, and an edge surface, b) providing a first, second, and third electronic components, c) mounting the first electronic component on the first surface and the second electronic component on the second surface, d) mounting the third electronic component over the edge surface of the PCB. The method is **characterized in that** a first terminal of the third electronic components is surface mounted to a contact terminal of the first electronic component, and a second terminal of the third electronic component is surface mounted to a contact terminal of the second electronic component.

Other objects, advantages and novel features of the invention will become more apparent from the following detailed description of the present embodiment when taken in conjunction with the accompanying drawings.

### BRIEF DESCRIPTION OF THE DRAWINGS

FIG. 1 shows an assembly before an edge component is mounted;
FIG. 2 is a perspective view of a printed circuit board assembly according to the present invention;
FIG. 3 is a cross-sectional view of a printed circuit board assembly according to the present invention;
FIG. 4 shows an assembly comprising an array of edge components;
FIG. 5 shows another embodiment with an edge component having four terminals;
FIG. 6A and 6B is a prior art assembly.

### DETAILED DESCCRIPTION

The invention is illustrated by the following examples.

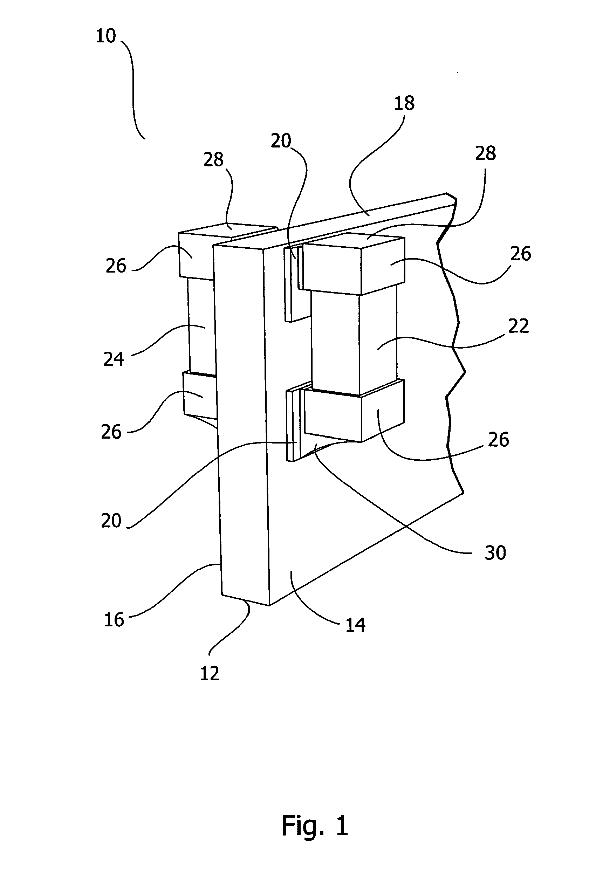

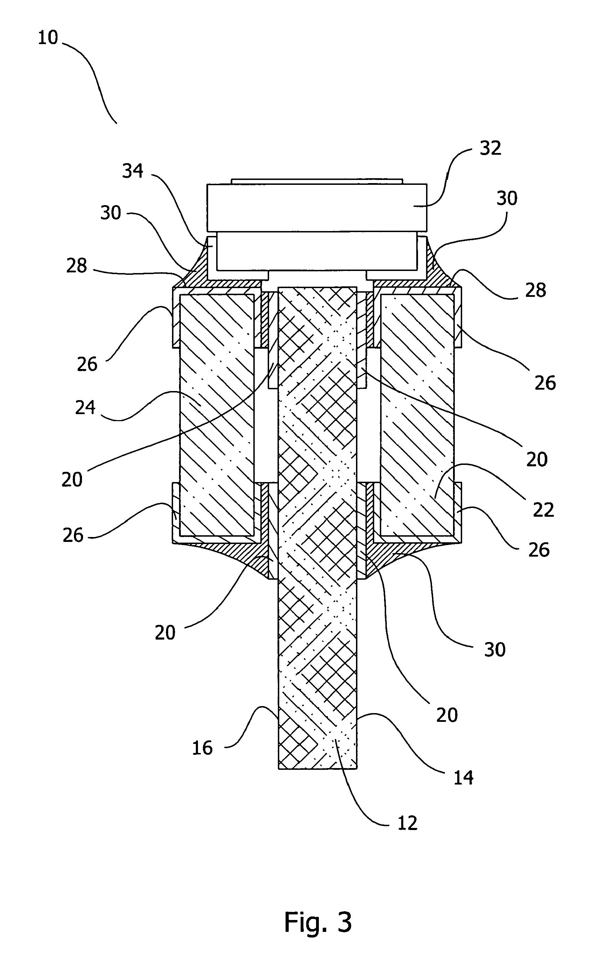

Referring to FIG. 1, FIG. 2, and FIG. 3, a printed circuit board assembly 10 in accordance with the present invention comprises a printed circuit board 12 (PCB) with two major mounting surfaces 14 and 16, each surface having a plurality of conductive traces (not shown) and mounting pads 20 or lands. The PCB 12 also has an edge surface 18, substantially orthogonal to both major surfaces 14 and 16. The printed circuit board assembly 10 further comprises a first electronic component 22 mounted on a first major surface 14 and a second electronic component 24 mounted on a second major surface 16. Each of the first and second electronic components 22 and 24 has two contact terminals 26 mounted onto PCB mounting pads 20, for example by way of reflow soldering. Alternatively, the electronic components 22 and 24 may be mounted by welding, or using a conducting adhesive or by any other method known in the art.

Advantageously, the first and second electronic components 22, 24 are SMT type resistors. SMT resistors are available in different forms and sizes and are cheap. These components may form a part of circuitry or may be used only for mounting edge components over them, in the latter case zero ohm resistors may be used, or the component terminals 26 may be electrically connected to one another or shortened by conductive traces on the PCB 12.

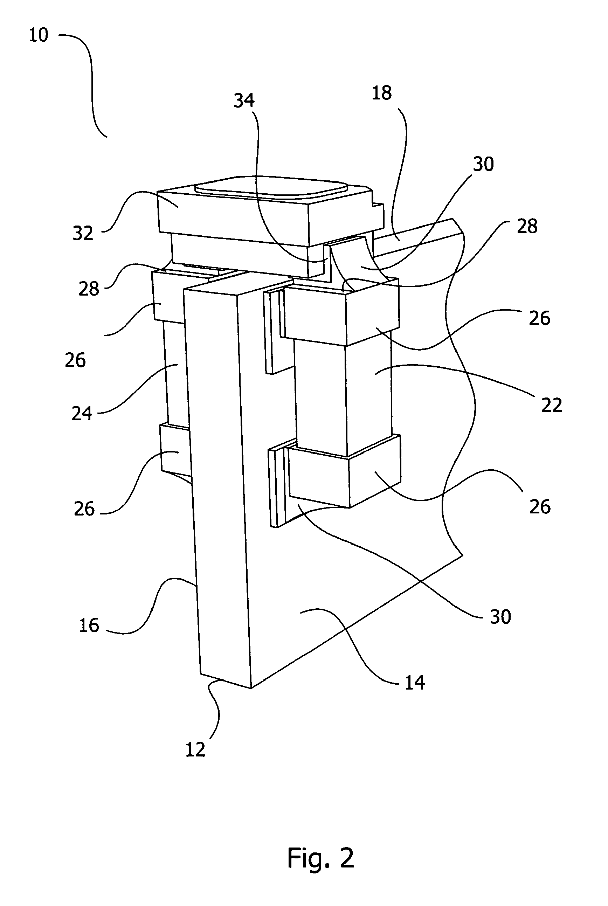

End parts 28 of the contact terminals 26 which are aligned with the edge surface 18 serve as a mounting pads for a third electronic component 32 (FIG. 2). The third electronic component 32, in this example, a light emitting diode (LED) in surface mount package, NSSW100 of Nichia, is surface mounted onto the end parts 28 of the contact terminals 26 by any surface mount method known in the art.

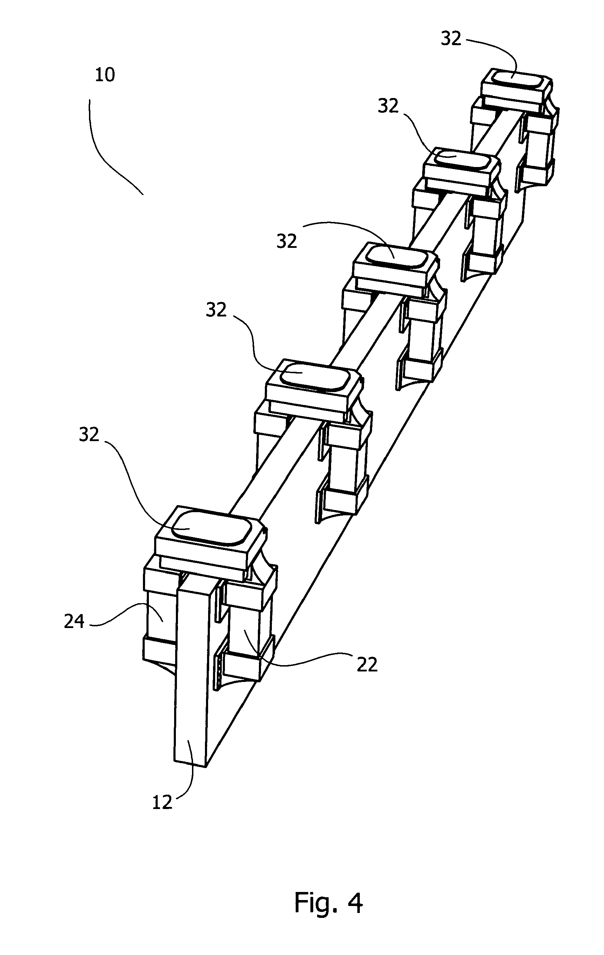

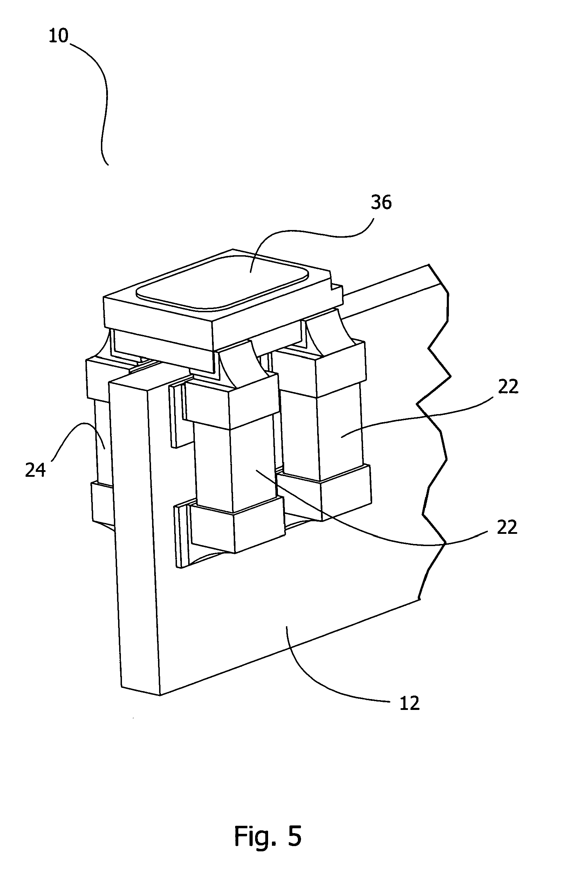

Only one edge component is shown on the Figs 1-3 for the sake of clarity. As seen on FIG. 4, the assembly 10 may contain a plurality or an array of such components 32. It is also apparent to those skilled in the art that the edge component 32 may have more than two terminals 34. On FIG. 5 is shown an example of a printed circuit board assembly 10 with an edge mounted LED package 36, NSSM026AB of Nichia, having four terminals. There are SMT LED packages having six terminals, for example NSSM0116D of Nichia, that also may be used in embodiments of the present invention.

The process of assembling the printed board assembly may include the following steps. Step one: providing a PCB having a first major surface, a second major surface, and an edge surface. Step two: mounting electronic components on first and second major surfaces by any method known in the art, preferably by SMT. Step three: applying solder on the end parts 28 of the contact terminals 26 of the electronic components 22 and 24 mounted on both major surfaces of the PCB 12, for example by solder print process. This may involve the use of a stencil fabricated with apertures at certain specified positions. The stencil is positioned above the edge PCB surface such that apertures in the stencil are positioned above each end part 28 of the contact terminals 26 of the electronic components 22 and 24. Solder is applied on the stencil and forced through the apertures in the stencil by a squeegee so that a desired amount of solder is deposited on the end parts 28 of the contact terminals 26. The PCB is then separated from the stencil, and the edge components 32 are placed atop the end parts 28.

Alternatively, the solder may be applied to the contacts terminals by direct solder paste dispensing using solder past dispenser equipment instead of solder print process.

The PCB assembly is then put through a solder reflow process where controlled heating is used to melt the solder. The PCB assembly is then allowed to cool, and as the solder solidifies, it bonds each terminal 34 of the edge component 32 to the corresponding end part 28 of the contact terminals 26 of the electronic components 22 and 24.

While preferred embodiments have been described, it will be apparent to those skilled in the art that various modifications can be made in the embodiments without departing from the spirit of the present invention. Such modifications are all within the scope of this invention.

To assist the reader in understanding the present invention, all reference numbers used herein are summarized in the table below, along with the elements they represent:
10 printed circuit board assembly (PCBA)
12 printed circuit board (PCB)
14 first major surface
16 second major surface
18 edge surface
20 mounting pad (on PCB)
22 first electronic component
24 second electronic component
26 contact terminal (first and second components)
28 end part of contact terminal (first and second components)
30 solder
32 third electronic component
34 contact terminal (third component)
36 third electronic component (with four terminals)
40 lamp assembly (prior art)
42 LED lamp (prior art)
44 LED lamp terminal (prior art)
46 circuit board (prior art)
48 pathways (prior art).

## Claims

1. A printed circuit board assembly (10), comprising:
a printed circuit board (12), having
a first major surface (14),
a second major surface (16), and
an edge surface (18);
a first electronic component (22) mounted on the first major surface (14);
a second electronic component (24) mounted on the second major surface (16); and
a third electronic component (32) disposed atop the edge surface (18),
**characterized in that**
a first contact terminal (34) of the third electronic component (32) is surface mounted to a contact terminal (26) of the first electronic component (22), and
a second contact terminal (34) of the third electronic component (32) is surface mounted to a contact terminal (26) of the second electronic component (24).

2. The printed circuit board assembly (10) of claim 1, wherein the third electronic component (32) comprises a light emitting diode.

3. The printed circuit board assembly (10) of claim 1, wherein the first and second electronic components (22, 24) are SMT type components.

4. The printed circuit board assembly (10) of claim 1, wherein the third electronic component (32) comprises four contact terminals (34), each respectively mounted on a contact terminal (26) of one of the first or second electronic components (22, 24).

5. The printed circuit board assembly (10) of claim 1, wherein the third electronic component (32) comprises six contact terminals (34), each respectively mounted on a contact terminal (26) of one of the first or second electronic components (22, 24).

6. The printed circuit board assembly (10) of claim 1, wherein the first and second electronic components (22, 24) are selected from the group consisting of: resistor, capacitor, LED, or other semiconductor device.

7. A method of assembling a printed circuit board assembly (10) comprising steps of:
a) providing a PCB (12) having
a first major surface (14),
a second major surface (16), and
an edge surface (18);
b) providing a first, second, and third electronic components (22, 24, 32);
c) mounting the first electronic component (22) on the first major surface (14) and the second electronic component (24) on the second major surface (16);
d) mounting the third electronic component (32) over the edge surface (18) of the PCB (12),
**characterized in that**
a first terminal (34) of the third electronic component (32) is surface mounted to a contact terminal (26) of the first electronic component (22), and
a second terminal (34) of the third electronic component (32) is surface mounted to a contact terminal (26) of the second electronic component (24).

8. The method of claim 7, wherein the step (d) of mounting the third electronic component (32) comprises steps of:
(e) applying solder on the contact terminals (26) of the first and second electronic components (22, 24);
(f) disposing the third electronic component (32) upon the contact terminals (26) of the first and second electronic components (22, 24); and
(g) subjecting the printed circuit board (12) to a solder reflow process.

9. The method of claim 8 wherein the step (e) of applying solder comprises steps of:
(h) providing a stencil having a first aperture and a second aperture;
(i) positioning the printed circuit board (12) below the stencil such that the first aperture is above the contact terminal (26) of the first electronic component (22) and the second aperture is above the contact terminal (26) of the second electronic component (24);
(j) applying solder on the stencil;
(k) forming the solder through the first aperture and the second aperture such that solder is deposited on the contact terminals (26) of the first and second electronic components (22, 24);
(l) separating the printed circuit board (12) from the stencil.

10. The method of claim 8, wherein the step (g) of solder reflow process comprises steps of:
(m) forming solder bonds between the first terminal (34) of the third electronic components (32) and the contact terminal (26) of the first electronic component (22):
(n) forming solder bonds between the second terminal (34) of the third electronic components and the contact terminal (26) of the second electronic component (24).
